# EUROPEAN PATENT APPLICATION

(11) **EP 4 495 687 A2**
(43) Date of publication of application: **22.01.2025**
(21) Application number: 24183587.5
(22) Date of filing: 21.06.2024
(51) Int. Cl.: G03F 7/00

(54) **AIR CONDITIONING SYSTEM, AIR CONDITIONING METHOD, AND ARTICLE MANUFACTURING METHOD**

(30) Priority: 21.07.2023 JP 2023118900
(71) Applicant: CANON KABUSHIKI KAISHA, Tokyo 146-8501 (JP)
(72) Inventor: SAKU, Tomonobu, Tokyo (JP)
(74) Representative: WESER & Kollegen Patentanwälte PartmbB

(57) **Abstract**

An air conditioning system S includes a heating element installation room R in which a heating element N is installed, a circulation air conditioning unit 10 configured to adjust a temperature of exhaust heat air B2 collected from the heating element installation room R to a predetermined temperature and returns it to the heating element installation room R, an air supply unit 30 configured to supply supplied air B3 from the outside CR of the circulation air conditioning unit 10, an air exhaust unit 40 configured to discharge the exhaust heat air B to the outside CR of the circulation air conditioning unit 10, and an air supply or exhaust adjustment unit 50 configured to adjust an air volume of the supplied air B3 and an air volume of discharged air B2b discharged from the air exhaust unit 40 on the basis of a difference in temperature between the supplied air B3 and the exhaust heat air B2.

## Description

### BACKGROUND OF THE INVENTION

### Field of the Invention

The present invention relates to an air conditioning system and the like in a semiconductor manufacturing device installation room.

### Description of the Related Art

Examples of a lithography device used in a lithography process for manufacturing articles such as semiconductor devices include, for example, an imprint device.

Semiconductor device manufacturing equipment such as an imprint device is housed in a semiconductor manufacturing device installation room provided within a clean room to accurately control temperature, humidity, and air cleanliness. The semiconductor manufacturing device installation room is a nearly sealed space, and its temperature adjustment management is performed independently from that of the clean room.

Japanese Unexamined Patent Application, First Publication No. H5-93542 describes an air conditioner that can maintain cleanliness of indoor air without significantly changing an indoor temperature.

Semiconductor device manufacturing equipment operates an actuator, which is a heating element, continuously throughout the year. For this reason, there is a need to efficiently adjust a temperature of a semiconductor manufacturing device installation room to reduce running costs.

However, in the air conditioner disclosed in Japanese Unexamined Patent Application, First Publication No. H5-93542, when the temperature inside the semiconductor manufacturing device installation room changes significantly, it is necessary to increase an output of a cooler and a heater, making it difficult to reduce running costs.

### SUMMARY OF THE INVENTION

One embodiment of the present invention provides an air conditioning system, an air conditioning method, and the like that can efficiently adjust a temperature of a semiconductor manufacturing device installation room.

The present invention in its first aspect provides an air conditioning system as specified in claims 1 to 8. The present invention in its second aspect provides an air conditioning method as specified in claim 9. The present invention in its third aspect provides an article manufacturing method as specified in claim 10.

Further features of the present invention will become apparent from the following description of exemplary embodiments with reference to the attached drawings.

### BRIEF DESCRIPTION OF THE DRAWINGS

Fig. 1 is a schematic diagram which shows an air conditioning system according to an embodiment.
Fig. 2 is a schematic diagram which shows a general configuration of the air conditioning system.
Fig. 3 is a flowchart diagram which shows an air conditioning method according to an embodiment.
Figs. 4A to 4F are schematic diagrams for describing a method for manufacturing an article.

### DESCRIPTION OF THE EMBODIMENTS

Embodiments of the present invention will be described below with reference to the drawings. However, the present invention is not limited to the following embodiments. In each drawing, the same members or elements are denoted by the same reference numerals, and descriptions thereof will be omitted.

### [Air conditioning system]

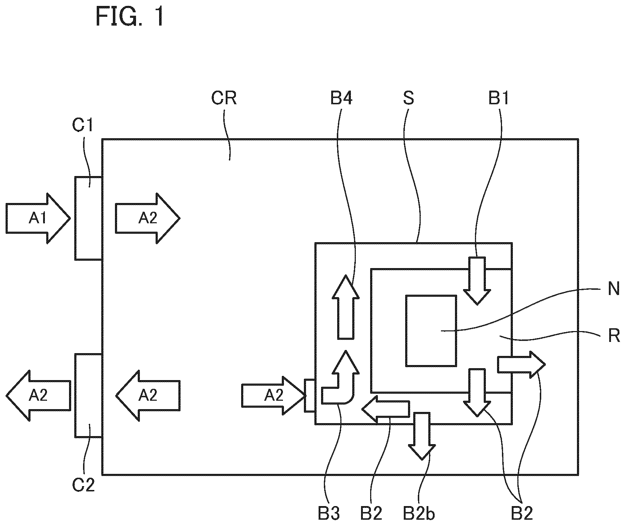

Fig. 1 is a schematic diagram which shows an air conditioning system S according to an embodiment of the present invention.

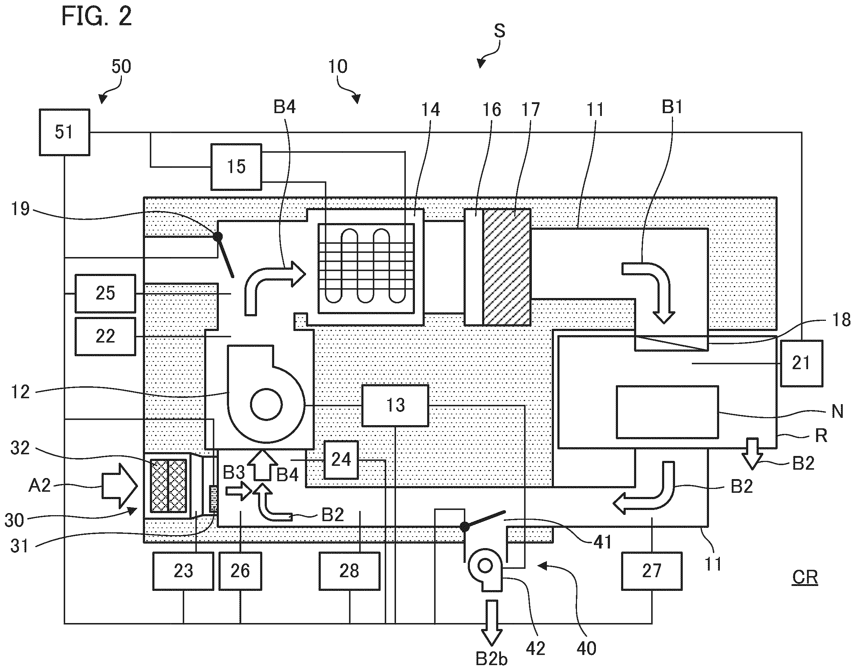

Fig. 2 is a schematic diagram which shows a general configuration of the air conditioning system.

The air conditioning system S is installed integrally with the semiconductor manufacturing device installation room (a heating element installation room) R, and performs air conditioning (temperature adjustment) of the semiconductor manufacturing device installation room R.

The semiconductor manufacturing device installation room R and the air conditioning system S are installed inside a clean room CR. The clean room (the outside) CR includes an air supply unit C 1 and an air exhaust system C2, and maintains an inside of the clean room CR at a constant temperature.

The air supply unit C 1 includes a heating coil, a cooling coil, a HEPA filter, and the like, adjusts a temperature of outside air A1 to a constant temperature, and then supplies the air into the clean room CR. Temperature-adjusted air A2 is supplied into the clean room CR. The inside of the clean room CR is filled with the air A2 at a temperature of 23°C. An error (an accuracy) of the air A2 is managed within ±2°C.

The air exhaust system C2 collects the air A2 from the clean room CR and exhausts it to the outside.

In the semiconductor manufacturing device installation room R, a semiconductor manufacturing device N such as an imprint device is installed. The semiconductor manufacturing device (a heating element) N has a large number of actuators. The semiconductor manufacturing device N has a maximum heat generation amount of about 2 kW. As the semiconductor manufacturing device N operates, the actuators generate heat, and a temperature inside the semiconductor manufacturing device installation room R rises.

The air conditioning system S supplies air at a constant temperature (temperature-adjusted air B1) to the semiconductor manufacturing device installation room R. At the same time, the air conditioning system S collects exhaust heat (exhaust heat air B2) due to the operation of the semiconductor manufacturing device N from the semiconductor manufacturing device installation room R. As a result, the semiconductor manufacturing device installation room R is maintained at a constant temperature.

Note that the semiconductor manufacturing device installation room R is not a completely sealed space, and a portion of air (the exhaust heat air B2) inside the semiconductor manufacturing device installation room R leaks into the clean room CR.

The air conditioning system S includes a circulation air conditioning unit 10, an air supply unit 30, an air exhaust unit 40, and an air supply or exhaust adjustment unit 50.

The circulation air conditioning unit 10 adjusts a temperature of the exhaust heat air B2 collected from the semiconductor manufacturing device installation room R to a predetermined temperature, and returns this temperature-adjusted air B1 to the semiconductor manufacturing device installation room R.

The circulation air conditioning unit 10 includes a circulation duct 11, a blower 12, a cooler 14, a heater 16, a chemical filter 17, an air supply port filter 18, and the like.

The circulation duct 11 is a wind conduit whose one end is connected to a floor surface of the semiconductor manufacturing device installation room R, and the other end is connected to a ceiling of the semiconductor manufacturing device installation room R. A cross-sectional area of the circulation duct 11 is known.

The exhaust heat air B2 is drawn (collected) into the circulation duct 11 from the floor surface of the semiconductor manufacturing device installation room R. Inside the circulation duct 11, the exhaust heat air B2 is changed to the temperature-adjusted air B1. The temperature-adjusted air B1 is blown out (supplied) from the ceiling of the semiconductor manufacturing device installation room R via the circulation duct 11.

The blower 12 is disposed inside the circulation duct 11 and causes the air (the temperature-adjusted air B1, the exhaust heat air B2, and mixed air B4) in the circulation duct 11 to flow (blow). The blower 12 is disposed approximately in the middle of a path of the circulation duct 11. The blower has, for example, a heat generation amount of about 850 W.

A rotation speed of the blower 12 is controlled by a blower inverter 13. During normal operation, the rotation speed of the blower 12 is maintained constant and the mixed air B4 is blown out at an air volume of 17 (m³/min).

The cooler 14 is disposed inside the circulation duct 11 downstream from the blower 12. The cooler 14 is connected to a cooling water circulator 15 and cools air (the air B4) passing through the cooler 14.

The heater 16 is disposed inside the circulation duct 11 on a downstream side of the cooler 14. The heater 16 heats the air that has passed through the cooler 14 and has been cooled.

The air that has passed through the cooler 14 and the heater 16 (the temperature-adjusted air B1) is temperature-adjusted to a predetermined temperature. In other words, the exhaust heat air B2 changes to the temperature-adjusted air B1 through the cooler 14 and the heater 16. The temperature-adjusted air B1 has a temperature of 23°C that is adjusted with an accuracy (an error) of 1/100 to 1/1000°C.

The chemical filter 17 is disposed on a downstream side of the heater 16. The chemical filter 17 removes (captures) toxic gases and minute acidic and basic particles contained in the temperature-adjusted air B1.

The air supply port filter 18 is disposed at a blowout port of temperature-adjusted air provided in the ceiling of the semiconductor manufacturing device installation room R. The air supply port filter 18 is a ULPA filter that removes dust (contamination) contained in the temperature-adjusted air B1.

In the circulation duct 11, a supply side exhaust valve 19 is provided between the blower 12 and the cooler 14. The supply side exhaust valve (supply side air exhaust unit) 19 functions as an adjustment valve for adjusting the air volume and air pressure of the mixed air B4 blown out from the blower 12 and flowing into the cooler 14.

The circulation air conditioning unit 10 has a plurality of sensors. Specifically, it has three thermometers 21 to 23, two pressure gauges 24 and 25, and three flow meters 26 to 28.

The thermometer 21 is disposed near a temperature-adjusted air blowout port of the semiconductor manufacturing device installation room R. The thermometer 21 measures a temperature of the temperature-adjusted air B1 supplied to the semiconductor manufacturing device installation room R.

A thermometer (a first thermometer) 22 is disposed in the circulation duct 11 on a downstream side of the blower 12. The thermometer 22 measures a temperature of the mixed air B4 (the exhaust heat air B2, the supplied air B3) blown out from the blower 12 before temperature adjustment.

A thermometer (a second thermometer) 23 is disposed in the circulation duct 11 on an upstream side of the blower 12. An air supply port of the air supply unit 30 is provided on the upstream side of the blower 12. The thermometer 23 measures a temperature of the supplied air B3 flowing into the circulation duct 11 from the air supply unit 30.

The pressure gauge 24 is disposed in the circulation duct 11 on the upstream side (suction side) of the blower 12. The pressure gauge 24 measures a pressure (a static pressure) of the mixed air B4 sucked into the blower 12.

The pressure gauge 25 is disposed in the circulation duct 11 on the downstream side (a discharge side) of the blower 12. The pressure gauge 25 measures the pressure (the static pressure) of the mixed air B4 discharged from the blower 12.

An operating status of the blower 12 can be confirmed by a difference in measured value (differential pressure) of the pair of pressure gauges 24 and 25.

A flow meter (a second flow meter) 26 is disposed in the circulation duct 11 on the upstream side of the blower 12. It measures a flow velocity of air (the supplied air B3) flowing into the circulation duct 11 from the air supply unit 30. An air volume of the supplied air B3 is determined according to a flow velocity of the supplied air B3 and a cross-sectional area of the circulation duct 11.

A flow meter (a first flow meter) 27 is disposed on the most upstream side of the circulation duct 11. It measures a flow velocity of the exhaust heat air B2 drawn into the circulation duct 11 from the floor surface of the semiconductor manufacturing device installation room R. An air volume of the exhaust heat air B2 is determined according to the flow velocity of the exhaust heat air B2 and the cross-sectional area of the circulation duct 11.

A flow meter (a first flow meter) 28 is disposed between the flow meter 26 and the flow meter 27 in the circulation duct 11. An exhaust port 41 of the air exhaust unit 40 is provided between the flow meter 26 and the flow meter 27. The flow meter 28 measures a flow velocity of air (the exhaust heat air B2) that continues to flow through the circulation duct 11 without being discharged from the air exhaust unit 40 (the exhaust port 41). The air volume of the exhaust heat air B2 is determined according to the flow velocity of the exhaust heat air B2 and the cross-sectional area of the circulation duct 11.

Furthermore, an air volume of exhaust heat air B2b discharged from the air exhaust unit 40 is determined according to a difference in measured values of the flow meter 27 and the flow meter 28 (a difference in flow velocity) and the cross-sectional area of the circulation duct 11.

The air supply unit 30 takes in air A2 inside the clean room CR into the circulation duct 11. The air supply unit 30 is disposed slightly downstream from the blower 12.

The air supply unit 30 has an air supply port 31 whose opening degree can be adjusted. The air supply unit 30 adjusts an air volume of air A2 (the supplied air B3) taken into the circulation duct 11 according to an opening degree of the air supply port 31. A chemical filter 32 is disposed in the air supply port 31.

The air A2 passes through the chemical filter 32, becomes the supplied air B3, and flows into the circulation duct 11. The supplied air B3 mixes with the air that continues to flow through the circulation duct 11 (the exhaust heat air B2).

As described above, part of the air (the exhaust heat air B2) in the semiconductor manufacturing device installation room R is leaking into the clean room CR. For this reason, during a normal operation, the air supply port 31 of the air supply unit 30 is always open to continue taking in the supplied air B3 into the circulation duct 11.

During the normal operation (in a normal operation mode), the air volume of the supplied air B3 is 5.0 (m³/min).

In an energy saving operation mode, the air supply unit 30 can further increase the opening degree of the air supply port 31 to take in a large amount of the supplied air B3. In the energy saving operation mode, the air volume of the supplied air B3 is 7.5 (m³/min).

The air exhaust unit 40 is disposed on an upstream side of the air supply unit 30. The air exhaust unit 40 discharges (exhausts) part of the exhaust heat air B2 (the exhaust heat air B2b) collected from the floor surface of the semiconductor manufacturing device installation room R to the outside of the circulation duct 11.

The air exhaust unit 40 has an exhaust port 41 (an exhaust valve) that can be opened and closed and a blower 42. The air exhaust unit 40 opens the exhaust port 41 and drives the blower 42 to forcibly exhaust the part of the exhaust heat air B2 (the exhaust heat air B2b) into the clean room CR.

During the normal operation, the exhaust port 41 of the air exhaust unit 40 is always closed. The air exhaust unit 40 operates when the air supply unit 30 takes in a large amount of the supplied air B3. That is, the air exhaust unit 40 operates in the energy saving operation mode.

The air exhaust unit 40 discharges the exhaust heat air B2 (the exhaust heat air B2b) corresponding to an increase in the amount of air (the supplied air B3) taken in from the air supply unit 30 to the outside. The air volume of the exhaust heat air B2b is 2.5 (m³/min), which is the same amount as the increase in the amount of the supplied air B3.

The air supply or exhaust adjustment unit 50 has an air conditioner control unit 51 and controls the air conditioning system S in an integrated manner.

The air conditioner control unit 51 controls the blower 12 (the blower inverter 13), the cooler 14 (the cooling water circulator 15), and the heater 16. The air conditioner control unit 51 also controls the air supply port 31 of the air supply unit 30 and the exhaust port 41 and the blower 42 of the air exhaust unit 40.

The air conditioner control unit 51 controls the blower 12 and the like on the basis of measured values of the thermometers 21 to 23, the pressure gauges 24 and 25, and the flow meters 26 to 28.

For example, the air conditioner control unit 51 determines a difference in temperature between the supplied air B3 and the exhaust heat air B2 on the basis of the measured values of the thermometers 22 and 23. Then, the air conditioner control unit 51 increases an intake amount of the supplied air B3 when this difference in temperature is large. Specifically, the air conditioner control unit 51 increases a rotation speed of the blower 12. At the same time, the opening degree of the air supply port 31 is expanded, and the exhaust port 41 and the blower 42 are operated.

Then, the air volume of the supplied air B3 supplied from the air supply unit 30 and the air volume of the exhaust air B2 discharged from the air exhaust unit 40 are adjusted. The air conditioner control unit 51 reduces the running costs of the air conditioning system S by taking in cold air (the supplied air B3) into the circulation duct 11.

### [Air conditioning method]

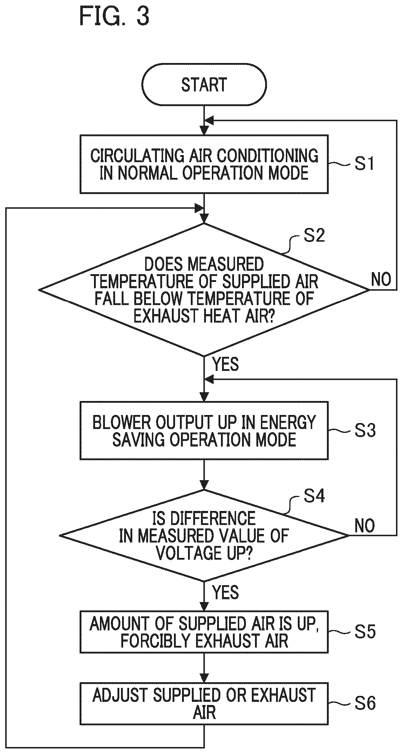

Fig. 3 is a flowchart which shows an air conditioning method according to the embodiment.

In the air conditioning system S, the air conditioner control unit 51 controls the cooler 14 and the heater 16 on the basis of the measured values of the thermometer 21. The temperature of the temperature-adjusted air B1 supplied to the semiconductor manufacturing device installation room R is maintained constant with high accuracy. Specifically, the temperature of the temperature-adjusted air B1 is maintained at 23°C, and the temperature is adjusted (controlled) with an accuracy of 1/100 to 1/1000°C.

This temperature adjustment control is always performed when the air conditioning system S is in operation.

### (Step S1: Circulating air conditioning process (step))

First, the air conditioning system S performs an operation (temperature adjustment) in the normal operation mode.

In the normal operation mode, the blower 12 operates while maintaining an air volume of 17 (m³/min). The mixed air B4 blown out from the blower 12 passes through the cooler 14 and the heater 16 and becomes the temperature-adjusted air B1. The temperature-adjusted air B1 is supplied to the semiconductor manufacturing device installation room R at the air volume of 17 (m³/min).

The exhaust heat air B2 is collected from the semiconductor manufacturing device installation room R at an air volume of 12.5 (m³/min). The exhaust port 41 of the air exhaust unit 40 is closed, and all of the exhaust heat air B2 is sent toward the blower 12.

The air supply unit 30 takes in the supplied air B3 from the air supply port 31. The air volume of the supplied air B3 is 5.0 (m³/min). The mixed air B4, which is obtained by merging and stirring the supplied air B3 and the exhaust heat air B2, is sucked into the blower 12.

As described above, the semiconductor manufacturing device N in the semiconductor manufacturing device installation room R has a maximum heat generation amount of about 2 kW. For this reason, if the semiconductor manufacturing device N continues to operate at a 50% output, the temperature of the exhaust heat air B2 is calculated to be 26.3°C. If the semiconductor manufacturing device N continues to operate at a 100% output, the temperature of the exhaust heat air B2 is calculated to be 29.6°C.

For example, when the temperature of the air A2 in the clean room CR is 21°C, the temperature of the supplied air B3 becomes 23.5°C due to an effect of heat adsorbed to the chemical filter 32, and the like. When the temperature of the air A2 is 25°C, the temperature of the supplied air B3 is 27.5°C. The temperature of the supplied air B3 is measured by the thermometer 23.

When the temperature of the exhaust heat air B2 is 29.6°C and the supplied air B3 having a temperature of 23.5°C is taken in from the air supply unit 30 and merged and stirred with the exhaust heat air B2, the mixed air B4 on the downstream side of the blower 12 has a temperature of 30.2°C. The temperature of mixed air B4 is measured by the thermometer 22.

In order to cool the temperature of this mixed air B4 to 23°C, it is necessary to increase an output of the cooler 14.

### (Step S2)

The air conditioner control unit 51 determines whether to shift to the energy saving operation mode.

The thermometer 23 constantly measures the temperature of the air (the supplied air B3) flowing into the circulation duct 11 from the air supply unit 30. The air conditioner control unit 51 determines to shift to the energy saving operation mode when the temperature of the supplied air B3 falls below the temperature of the exhaust heat air B2. That is, the air conditioner control unit 51 determines to shift to the energy saving operation mode on the basis of the difference in temperature between the supplied air B3 and the exhaust heat air B2.

More specifically, based on when the air volume of the supplied air B3 is 5.0 (m³/min) and the temperature is 25.5°C, and the air volume of the exhaust heat air B2 is 15 (m³/min) and the temperature is 29.6°C, it is determined whether to shift to the energy saving operation mode.

Specifically, a total value (a determination value) of a product of the air volume and temperature of each of the supplied air B3 and the exhaust heat air B2 is determined. (Determination value) =5×25.5+15×29.6=571.5

A value of this determination value is set as a threshold value.

For example, when the air volume of the supplied air B3 is 7.5 (m³/min), the temperature is 23.7°C, the air volume of the exhaust heat air B2 is 12.5 (m³/min), and the temperature is 31°C, the total value (the determination value) of the air volume and the temperature is as follows.

### (Determination value) =7.5×23.7+12.5×31=565.2

The determination value at this time falls below the threshold value. For this reason, the air conditioner control unit 51 determines to shift to the energy saving operation mode.

On the other hand, when the determination value exceeds the threshold value, the air conditioner control unit 51 returns to step S1 and maintains the normal operation mode.

### (Step S3)

When it shifts to the energy saving operation mode, the air conditioner control unit 51 instructs the blower 12 to increase its output (change its output).

### (Step S4)

Next, the air conditioner control unit 51 monitors the operating status of the blower 12 according to a difference in measured values (a difference in air pressure) of the pressure gauge 24 and the pressure gauge 25. In other words, an output status of the blower 12 is confirmed. If the difference in measured values of the pressure gauge 24 and the pressure gauge 25 is large, it can be confirmed that the blower 12 is operating to increase its output.

On the other hand, if the difference in measured values of the pressure gauge 24 and the pressure gauge 25 is not large, the procedure returns to step S3 and instructs the blower 12 to increase the output again.

### (Step S5: Air supply process, air exhaust process (step))

Then, the air conditioner control unit 51 instructs the air supply unit 30 to increase the opening degree of the air supply port 31. It causes the air volume (supplied air volume) of supplied air B3 to be raised (increased) from 5 (m³/min) to 7.5 (m³/min).

At the same time, the air conditioner control unit 51 instructs the air exhaust unit 40 to open the exhaust port 41 and to operate the blower 42. The exhaust heat air B2 (the exhaust heat air B2b) is discharged to the outside by an amount of increase in the air volume of the supplied air B3. That is, the exhaust heat air B2b is forcibly exhausted from the exhaust port 41 at an air volume of 2.5 (m³/min).

### (Step S6: Air supply or exhaust adjustment process (step))

The air supply or exhaust adjustment unit 50 makes the air volume of the exhaust air B2b equal to an amount of increase in the air volume of the supplied air B3. That is, the air supply or exhaust adjustment unit 50 balances the amount of increase in the air volume of the supplied air B3 and the air volume of the exhaust air B2b (air supply/exhaust adjustment).

The air conditioner control unit 51 controls the cooler 14 on the basis of the measured value of the thermometer 21. When the temperature of the mixed air B4 is 28.6°C, the mixed air B4 is cooled by the cooler 14 and is lowered to 23°C.

When the temperature of the temperature-adjusted air B1 becomes 23°C or lower due to supercooling by the cooler 14, the mixed air B4 is heated by the heater to raise the temperature-adjusted air B1 to 23°C.

The temperature of the air A2 in the clean room CR and the heat generation amount of the semiconductor manufacturing device N continue to change. In other words, the temperatures of the supplied air B3 and the exhaust heat air B2 also change. For this reason, the air conditioner control unit 51 continues to control the cooler 14 and the heater 16 so that the temperature of the temperature-adjusted air B1 is constant at 23°C.

Then, the procedure returns to step S2 and the processing described above is performed again.

In the normal operation mode of the air conditioning system S, when the maximum heat generation amount of the semiconductor manufacturing device N is approximately 2 kW, the exhaust heat air B2 has an air volume of 12.5 (m³/min) and a temperature of 31.0°C.

In the energy saving operation mode, when the temperature of the air A2 in the clean room CR is 22°C, the air A2 is sucked in from the air supply port 31 at an air volume of 7.5 (m³/min) and a temperature of the supplied air B3 that has passed through the chemical filter 32 becomes 23.7°C.

As a result, the temperature of the mixed air B4 on the upstream side of the blower 12 becomes 28.2°C. The temperature of the mixed air B4 on the upstream side of the blower 12 becomes 30.4°C.

Therefore, an amount of work done by the cooler 14 is a difference in temperature of 7.4°C between the temperature-adjusted air B1 (23°C) and the mixed air B4 (30.4°C).

On the other hand, in a conventional air conditioning system (in the normal operation mode only), when the maximum heat generation amount of the semiconductor manufacturing device N is approximately 2 kW, the exhaust heat air B2 has an air volume of 15.0 (m³/min) and a temperature of 29.6°C.

When the air A2 in the clean room CR has a temperature of 22°C, the supplied air B3 that is obtained by the air A2 having been sucked in from the air supply port 31 at an air volume of 5.0 (m³/min) and having passed through the chemical filter 32 has a temperature of 24.5°C.

As a result, the temperature of the mixed air B4 on the upstream side of the blower 12 becomes 28.3°C. The mixed air B4 on the upstream side of the blower 12 has a temperature of 30.52°C.

Therefore, the amount of work done by the cooler 14 is the difference in temperature of 7.52°C between the temperature-adjusted air B1 (23°C) and the mixed air B4 (30.52°C).

In the air conditioning system S, an amount of heat processed by the cooler 14 is 3109.1 (W/year) throughout a year. When it is converted into electrical energy, it is approximately 27235.7kWH.

In the conventional air conditioning system (in the normal operation mode only), it is 3161.7 (W/year). When it is converted into electrical energy, it is approximately 27696.5kWH.

In this manner, according to the air conditioning system S, an annual energy saving effect is 460.7 kWH.

In this way, the air conditioning system S adjusts the air volume of the supplied air B3 supplied from the air supply unit 30 and the air volume of the exhaust air B2b discharged from the air exhaust unit 40 on the basis of the difference in temperature between the supplied air B3 and the exhaust heat air B2.

By taking in cold air (the supplied air B3) into the circulation duct 11 and discharging part of the heated air (the exhaust air B2b) from the circulation duct 11, the running costs of the air conditioning system S can be reduced.

### <Example related to article manufacturing method>

An article manufacturing method according to the present embodiment is suitable for manufacturing articles such as a micro device such as a semiconductor device and an element having a fine structure. The article manufacturing method of this example includes a process of forming a pattern on a composition applied to a substrate using an imprint device (the semiconductor manufacturing device N) described above (a process of performing processing on the substrate), and a process of processing a substrate on which a pattern has been formed by such a process. Additionally, such a manufacturing method includes other well-known processes (oxidation, deposition, vapor deposition, doping, planarization, etching, composition stripping, dicing, bonding, packaging, and the like). The article manufacturing method of this example is advantageous in at least one of article performance, quality, productivity, and production cost compared to conventional methods.

A pattern of a cured product molded using an imprint device (the semiconductor manufacturing device N) is used permanently on at least some of various articles, or temporarily when various articles are manufactured. An article is an electric circuit element, an optical element, a MEMS, a recording element, a sensor, a mold, or the like. Examples of an electric circuit element include a volatile or nonvolatile semiconductor memory such as a DRAM, an SRAM, a flash memory, or an MRAM, and a semiconductor element such as an LSI, a CCD, an image sensor, or an FPGA. Examples of a mold include a mold for substrate processing such as imprinting.

The pattern of the cured product can be used as it is as a component of at least a part of the article, or can be used temporarily as a composition mask. After etching, ion implantation, or the like is performed in the substrate processing process, the composition mask is removed.

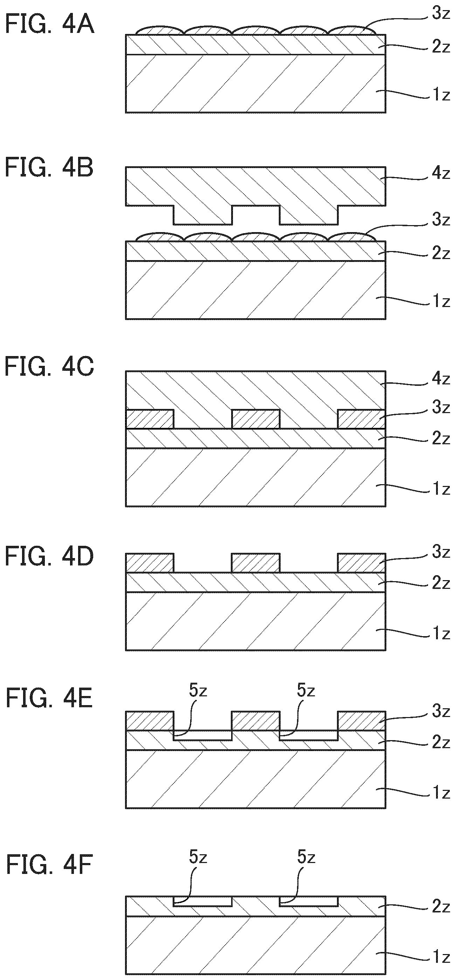

Next, a specific method for manufacturing an article will be described with reference to FIGS. 4A to 4F. As shown in Fig. 4(A), a substrate 1z such as a silicon substrate on which a workpiece 2z such as an insulator is formed is prepared, and then a composition 3z is applied to a surface of the workpiece 2z by an inkjet method or the like. Here, a state in which a plurality of droplet-shaped compositions 3z are applied onto a substrate 1z is shown.

As shown in Fig. 4B, a mold 4z is caused to have the side on which an uneven pattern is formed facing the composition 3z on the substrate 1z. As shown in Fig. 4C, the substrate 1z to which the composition 3z has been applied is brought into contact with the mold 4z, and pressure is applied (contact process). The composition 3z is filled into gaps between the mold 4z and the workpiece 2z. In this state, when light is emitted as an energy for curing through the mold 4z, the composition 3z is cured (curing process). At this time, in this example, it is possible to irradiate the composition with light at an irradiation amount to provide an optimum degree of photopolymerization based on spectral sensitivity characteristics acquired within the device.

As shown in Fig. 4D, after the composition 3z is cured, when the mold 4z and the substrate 1z are separated, a pattern of the cured product of the composition 3z is formed on the substrate 1z (a pattern forming process, a molding process). In the pattern of this cured product, a concave portion of the mold 4z has a shape corresponding to a convex portion of the cured product, that is, a concavo-convex pattern of the mold 4z has been transferred to the composition 3z.

As shown in Fig. 4E, when etching is performed using the pattern of the cured material as an etching-resistant mask, portions of the surface of the workpiece 2z where there is no cured product or thin remaining cured product are removed to form grooves 5z. As shown in Fig. 4(F), when the pattern of the cured material is removed, an article in which the grooves 5z are formed on a surface of the workpiece 2z can be obtained. Although the pattern of the cured product is removed here, it may be used as an interlayer insulation film, that is, a constituent member of an article, included in a semiconductor element, and the like without being removed even after processing. Although an example has been described in which a circuit pattern transfer mold provided with a concavo-convex pattern is used as the mold 4z, a flat template having a flat portion without a concave-convex pattern may also be used.

### <Other embodiments>

Although a preferred embodiment of the present invention has been described above, the present invention is not limited to the embodiment, and various modifications and changes can be made within a scope of the gist thereof. In addition, various numerical values used in the description above are merely examples, and the present invention is not limited to the numerical values described above.

The various numerical values (a heat amount, a temperature, an air volume, and the like) described in the embodiment described above are merely examples, and various modifications and changes can be made.

The semiconductor manufacturing device N is not limited to the imprint device, but may be any of various semiconductor manufacturing devices. Moreover, the device is not limited to a semiconductor manufacturing device, and may be a device having a heat source.

In addition, the present invention is not limited to a case where the semiconductor manufacturing device N is housed in the semiconductor manufacturing device installation room R.

### (Other embodiments)

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An air conditioning system (S) comprising:
a heating element installation room (R) in which a heating element (N) is installed;
a circulation air conditioning unit (10) configured to adjust a temperature of exhaust heat air (B2) collected from the heating element installation room to a predetermined temperature and return it to the heating element installation room;
an air supply unit (30) configured to supply supplied air from the outside of the circulation air conditioning unit;
an air exhaust unit (40) configured to discharge the exhaust heat air to the outside of the circulation air conditioning unit; and
an air supply or exhaust adjustment unit (50) configured to adjust an air volume of the supplied air and an air volume of discharged air discharged from the air exhaust unit on the basis of a difference in temperature between the supplied air and the exhaust heat air.

2. The air conditioning system according to claim 1,
wherein the air supply or exhaust adjustment unit balances the air volume of the supplied air and the air volume of the discharged air.

3. The air conditioning system according to claim 2,
wherein the air supply or exhaust adjustment unit increases the air volume of the supplied air when an amount of heat of the supplied air and the discharged air is below a threshold value, and makes the air volume of the discharged air the same amount as an increase in the air volume of the supplied air.

4. The air conditioning system according to any one of claims 1 to 3,
wherein the air supply or exhaust adjustment unit includes
a first thermometer (22) configured to measure a temperature of air before temperature adjustment,
a second thermometer (23) configured to measure a temperature of the supplied air,
a first flow meter (27, 28) configured to measure an air volume of the discharged air, and
a second flow meter (26) configured to measure an air volume of the supplied air.

5. The air conditioning system according to any one of claims 1 to 4,
wherein the air supply or exhaust adjustment unit
includes a pair of pressure gauges (24, 25) configured to measure a differential pressure in air between upstream and downstream sides of a blower that are provided in the circulation air conditioning unit,
instructs the blower to change an output, and monitors an output status of the blower according to the differential pressure in air.

6. The air conditioning system according to any one of claims 1 to 5,
wherein the circulation air conditioning unit supplies air to the heating element installation room through a ULPA filter.

7. The air conditioning system according to any one of claims 1 to 6,
wherein the circulation air conditioning unit includes a supply side air exhaust unit (19) that adjusts an air volume or a pressure of air supplied to the heating element installation room.

8. The air conditioning system according to any one of claims 1 to 7,
wherein the heating element installation room is installed in a clean room, and the supplied air is temperature-adjusted air in the clean room.

9. An air conditioning method comprising:
a circulating air conditioning step of adjusting a temperature of exhaust heat air collected from a heating element installation room in which a heating element is installed to a predetermined temperature and returning it to the heating element installation room;
an air supply step (S1) of supplying supplied air from the outside;
an exhaust step (S5) of discharging the exhaust heat air to the outside; and
an air supply or exhaust adjustment step (S5) of adjusting an air volume of the supplied air and an air volume of the discharged air discharged to the outside on the basis of a difference in temperature between the supplied air and the exhaust heat air.

10. An article manufacturing method comprising:
a step of performing pattern formation on a substrate using an imprint device installed in an air conditioning system that includes a heating element installation room in which the imprint device is installed as the heating element, a circulation air conditioning unit that adjusts a temperature of exhaust heat air collected from the heating element installation room to a predetermined temperature and returns it to the heating element installation room, an air supply unit that supplies supplied air from the outside of the circulation air conditioning unit, an air exhaust unit that discharges the exhaust heat air to the outside of the circulation air conditioning unit, an air supply or exhaust adjustment unit that adjusts an air volume of the supplied air and an air volume of the discharged air discharged from the air exhaust unit on the basis of a difference in temperature between the supplied air and the exhaust heat air; and
a step of processing the substrate subjected to the pattern formation in the previous process.
